(19) Europäisches Patentamt

European Patent Office

Office européen des brevets

(11) **EP 3 093 771 A2**

(12) **EUROPEAN PATENT APPLICATION**

(43) Date of publication:
**16.11.2016 Bulletin 2016/46**

(51) Int Cl.:
**G06F 17/10** *(2006.01)*

(21) Application number: **16275072.3**

(22) Date of filing: **05.05.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **06.05.2015 GR 20150100207**
**08.06.2015 GB 201509866**

(71) Applicant: **Airbus Operations Limited**
**Bristol BS34 7PA (GB)**

(72) Inventors:
• **PAPADOPOULOS, Chris**
  **Filton, Bristol BS37 7PA (GB)**
• **BLANCHE, Alberto Bernad**
  **Filton, Bristol BS37 7PA (GB)**
• **TIGANI, Serena**
  **Filton, Bristol BS37 7PA (GB)**

(74) Representative: **Burt, Matthew Thomas et al**
**Abel & Imray**
**20 Red Lion Street**
**London WC1R 4PQ (GB)**

(54) **METHODS AND SYSTEMS FOR TRANSFORMING FAULT TREE DIAGRAMS OF ENGINEERING SYSTEMS**

(57)     A method of transforming a fault tree diagram of an engineering system. The fault tree diagram comprises a plurality of cut-set matrices, wherein for each cut-set matrix, each column of the cut-set matrix corresponds to an event of the system, and each row of the cut-set matrix indicates a combination of occurred events; and a plurality of logic gates, wherein each logic gate takes as input one or more of the cut-set matrices and/or one or more outputs from other logic gates of the plurality of logic gates. At least one logic gate that has as inputs one or more cut-set matrices only is selected. A set of events is determined, wherein each event corresponds to a column of the one or more cut-set matrices of the selected logic gate. A replacement cut-set matrix for the selected logic gate is then determined, wherein each column of the replacement cut-set matrix corresponds to an event from the set of events, and each row indicates a combination of events obtained from the rows from the one or more cut-set matrices in accordance with the selected logic gate. The selected logic gate is then replaced with the replacement cut-set matrix.

FIG. 3c

**Description**

FIELD OF THE INVENTION

The present invention concerns methods and systems for transforming fault tree diagrams of engineering systems into a more summarised form. More particularly, but not exclusively, the invention concerns the transformation of fault tree diagrams comprising a combination of cut-set matrices and logic gates, by replacing at least one logic gate with a replacement cut-set matrix.

BACKGROUND OF THE INVENTION

Fault tree diagrams are used to represent combinations of faults in the components of an engineering system, for example an aircraft. Fault tree diagrams can for example be used to demonstrate compliance of an engineering system with a safety requirement defined by an official regulation, for example EASA CS25.1309.

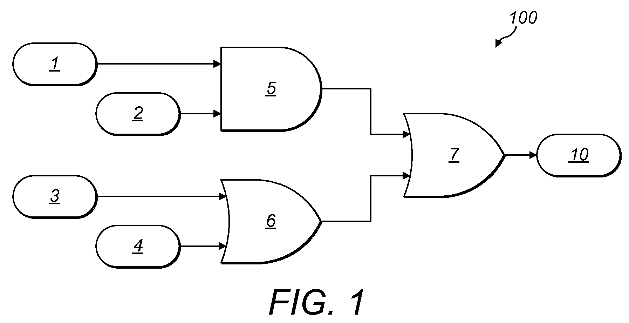

An example of a fault tree diagram is shown in Figure 1. The fault tree diagram 100 take as input events 1 to 4, which correspond to potential failure modes in components of the engineering system, and an output 10, which corresponds to the failure of the engineering system as a whole. The fault tree diagram 100 further comprises an AND gate 5 which takes as input events 1 and 2, an OR gate 6 takes as input events 3 and 4, and an OR gate 7 which takes as input the outputs of the AND gate 5 and OR gate 6. The output of the OR gate 7 is the output 10 of the fault tree diagram as a whole. The technical name of output 10 is the "Failure Condition". It is also referred to as the "Feared Event".

Thus, the fault tree diagram indicates that the engineering system will arrive at a failure condition if both event 1 and event 2 occur, or if event 3 or event 4 occurs. The term "Cut-Set" is used to describe each single event or combination of events that results in the failure condition. A Minimal-Cut-Set is a set of events that only contains the minimum number of events that result in the failure condition. The size of a minimal cut-set (MCS) is described as follow. An MCS that has only one event is said to be of order 1. An MCS that has a minimum of two events that result in a failure condition is said to be of order 2, and so on.

The cut-sets for the fault tree represented in diagram 100 include the following combinations of events:

　　1. Single Order MCS:

　　　　a. Event 3,
　　　　b. Event 4.

　　2. Second Order MCS:

　　　　a. Event 1 AND Event 2.

. A cut-set is recorded as a set of binary values in matrix form, one for each event of the fault tree diagram, each indicating whether its corresponding event has occurred or not. For example, for the fault tree diagram 100 an example cut-set is (0,1,0,1), which indicates that events 2 and 4 (only) have occurred resulting in the failure condition occurring. Note that in the example event 2 is not needed and so this cut-set would not be considered as minimal. Any other binary values could be used, for example True and False.

A cut-set is minimal if its combination of events results in the fault tree diagram indicating the failure of the engineering system as a whole, and no event can be changed from 1 to 0 without the fault tree diagram no longer indicating the failure of the engineering system as a whole. Cut-set analysis involves obtaining all the minimal cut-sets for a fault tree diagram. For example, the fault tree diagram 100 has minimal cut-sets (1,1,0,0), (0,0,1,0) and (0,0,0,1), as failure of the engineering system occurs if events 1 and 2 occur together, or if event 3 occurs, or if event 4 occurs.

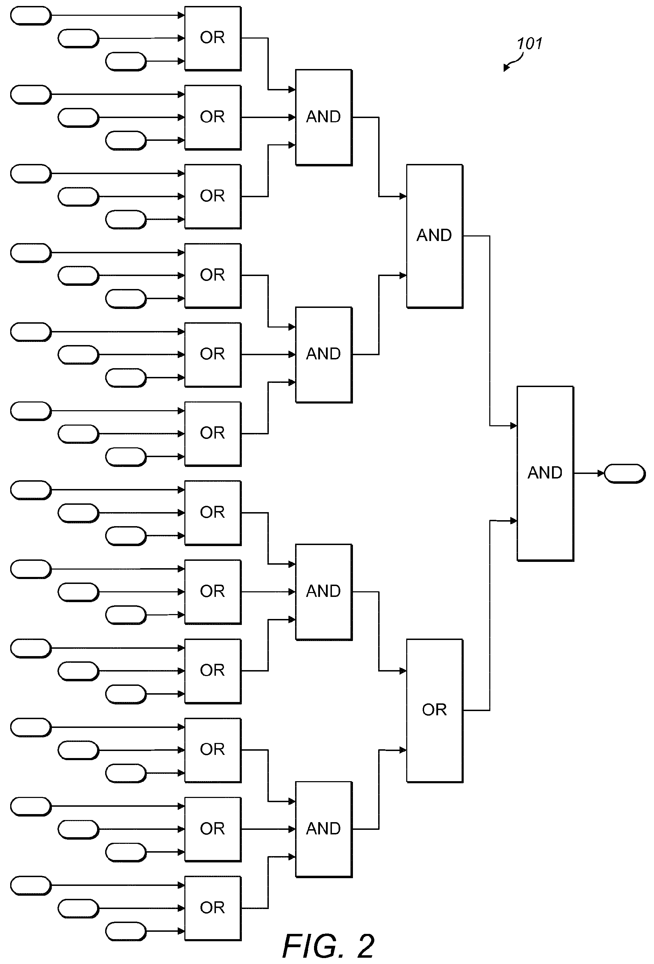

It is a disadvantage of cut-set analysis that the number of minimal cut-sets for an engineering system can be very large. For example, the fault tree diagram 101 shown in Figure 2 with 36 inputs has 39,336 minimal cut-sets. It is not unusual for large engineering systems to have thousands of inputs, which can result in millions of minimal cut-sets. Such large numbers of cut-sets make analysis by a user at best onerous, and at worst impossible.

The present invention seeks to mitigate the above-mentioned problems. Alternatively or additionally, the present invention seeks to provide improved methods and systems for transforming fault tree diagrams of engineering systems.

SUMMARY OF THE INVENTION

In accordance with a first aspect of the invention there is provided a method of transforming a fault tree diagram of an engineering system, wherein the fault tree diagram comprises:

　　a plurality of cut-set matrices, wherein for each cut-set matrix, each column of the cut-set matrix corresponds to an event of the system, and each row of the cut-set matrix indicates a combination of occurred events;
　　a plurality of logic gates, wherein each logic gate takes as input one or more of the cut-set matrices and/or one or more outputs from other logic gates of the plurality of logic gates;

wherein the method comprises the steps of:

　　selecting at least one logic gate that has as inputs one or more cut-set matrices only;
　　determining a set of events, wherein each event corresponds to a column of the one or more cut-set matrices of the selected logic gate;
determining a replacement cut-set matrix for the selected logic gate, wherein each column of the replacement cut-set matrix corresponds to an event from the set of events, and each row indicates a combination of events obtained from the rows from the one or more cut-set matrices in accordance with the selected logic gate;
replacing the selected logic gate with the replacement cut-set matrix.

The cut-set matrices provide a convenient and easily manipulated way of storing the information about combinations of occurred events required by the fault tree diagram. The fault tree diagram can then be conveniently transformed by replacing a selected logic gate with a replacement cut-set matrix, where the replacement cut-set matrix is determined from the logic gate and the cut-set matrices that provide its inputs.

Advantageously, the method further comprises prior to step 1 the step of obtaining a threshold for the maximum number rows in a cut-set matrix, and wherein step 4 is performed only in the case that the number of rows in the replacement cut-set matrix is within the threshold. This allows logic gates to be collapsed only when the replacement cut-set matrix is small enough to make it practical for it to be analysed by the user. In this case, when the number of rows in the replacement cut-set matrix is not within the threshold, the selected logic gate is marked as non-collapsible. Advantageously in this case, a logic gate is selected in step 1 only if it is not marked as non-collapsible. This allows the method to be performed efficiently as a logic gate previously marked as non-collapsible will not be selected for analysis on a subsequent occasion.

Preferably, the method further comprises prior to step 1 the steps of:

obtaining a fault tree diagram of an engineering system comprising:

a plurality of fault tree inputs, each input corresponding to an event of the system;
a plurality of logic gates, wherein each logic gate takes as input one or more of the plurality of fault tree inputs and/or one or more outputs from other logic gates of the plurality of logic gates;

for each input of a logic gate corresponding to an event of the system, determining a corresponding element in a cut-set matrix, wherein one column of the cut-set matrix corresponds to the event of the system, and at least one row of the cut-set matrix indicates the event of the system alone;
obtaining a replacement fault tree diagram from the obtained fault tree diagram, by replacing the inputs of the logic gates that are events with their corresponding cut-set matrices;

performing the subsequent steps of the method on the replacement fault tree diagram. This allows the method to be performed upon conventional fault tree diagrams. In this case, the method may further comprise subsequent to step 4 the step of obtaining an output fault tree diagram from the transformed fault tree diagram, by replacing the inputs of the logic gates that are cut-set matrices with their corresponding events. This allows a conventional fault tree diagram to be provided as the result of the method, which can then be manipulated using a conventional fault tree diagram, for example.

Preferably, the steps of the method are iterated over the logic gates in the fault tree diagram. This allows all of the fault tree diagram to be fully transformed.

In the case that in step 1 the selected logic gate is an OR gate, preferably in step 3 the replacement cut-set matrix is determined by concatenating the rows of cut-set matrices that are the inputs to the logic gate. In the case that in step 1 the selected logic gate is an AND gate, preferably in step 3 the replacement cut-set matrix is determined by concatenating each combination of rows from each cut-set matrix that is an inputs to the logic gate. In either case, preferably the method further comprises the step of removing redundant rows from the replacement cut-set matrix. In this case, advantageously the step of removing any redundant rows from the replacement cut-set matrix comprises:

re-ordering the rows of the replacement cut-set matrix according to the number of occurred events they indicate;
iterating through the rows in the replacement cut-set matrix, for each iterated row:

for each row that occurs later than the iterated row in the cut-set matrix:

determining a new row by AND-ing each column for an event in the iterated row with the corresponding column for the event in the later row, and
in the case that new row is equal to the iterated row, removing the later row from the replacement cut-set matrix.

In accordance with a second aspect of the invention there is provided a method of transforming a fault tree diagram of an engineering system, wherein the fault tree diagram comprises:

a plurality of fault tree inputs, each input corresponding to an event of the system, wherein each event has an associated failure mode type;
a plurality of logic gates, wherein each logic gate takes as input one or more of the plurality of fault tree inputs and/or one or more outputs from other logic gates of the plurality of logic gates;

wherein the method comprises the steps of:

1) selecting at least one logic gate the inputs of which comprise a plurality of inputs corresponding to events of the system, wherein the events have the same associated failure mode type;
2) replacing the plurality of inputs with a new input corresponding to a new event.

By replacing the inputs corresponding to events in this way, the fault tree diagram can be simplified. However, as the replaced inputs have the same associated failure mode type, the nature new event corresponding to the new input that replaced the previous inputs will be intuitively understandable to a user considering the fault tree diagram. Information regarding the new input can be easily constructed from the information regarding the replaced inputs, and stored for reference by a user.

Preferably, the selected logic gate is an OR gate.

The selected logic gate may have as inputs only the plurality of inputs with the same associated failure mode type, in which case advantageously the selected logic gate and the plurality of inputs are replaced with the new input. This simplifies the fault tree diagram further by replacing the logic gate as well as the inputs.

Preferably, the method is iterated over the fault tree diagram until there are no further logic gates that can be replaced. This allows the fault tree diagram to be simplified according to the method to the maximum extent.

In accordance with a third aspect of the invention there is provided any of the methods described in accordance with the first aspect discussed above, further comprising the steps of any of methods described in accordance with the second aspect discussed.

In either of the preceding aspects of the invention, the engineering system may be an airplane. Alternatively, the engineering system may be an airplane subsystem. Alternatively, the engineering system may be any other appropriate engineering system.

In accordance with a fourth aspect of the invention there is provided a computer system for transforming a fault tree diagram of an engineering system, wherein the computer system comprises:

at least one processor;
memory in communication with the processor;

and wherein the at least one processor is arranged to perform any of the methods described above on a fault tree diagram stored in the memory.

In accordance with a fifth aspect of the invention there is provided a computer program product arranged, when executed on a computer system, to perform any of the methods described above.

In accordance with a sixth aspect of the invention there is provided a computer program product arranged, when executed on a computer system, to provide the computer system described above.

In accordance with a sixth aspect of the invention there is provided a fault tree diagram transformed using any of the methods, or the computer system, described above.

It will of course be appreciated that features described in relation to one aspect of the present invention may be incorporated into other aspects of the present invention.

DESCRIPTION OF THE DRAWINGS

Embodiments of the present invention will now be described by way of example only with reference to the accompanying schematic drawings of which:

Figure 1 shows a conventional fault tree diagram;
Figure 2 shows another conventional fault tree diagram;
Figure 3a shows the fault tree diagram of Figure 1 transformed in accordance with an embodiment of the invention;
Figure 3b shows the fault tree diagram of Figure 1 further transformed in accordance with the embodiment of the invention;
Figure 3c shows the fault tree diagram of Figure 1 further transformed in accordance with the embodiment of the invention;
Figure 4 is a flowchart showing the steps taken for the removal of redundant rows from a cut-set matrix in accordance with an embodiment of the invention;
Figures 5a to 5c are flowcharts showing the transformation of a fault tree diagram in accordance with another embodiment of the invention
Figures 6a and 6b show the transformation of a fault tree diagram in accordance with an embodiment of a different aspect of the invention; and
Figures 7a and 7b show the transformation of a fault tree diagram in accordance with another embodiment of the invention.

DETAILED DESCRIPTION

A method of transforming a fault tree diagram in accordance with an embodiment of the invention is now described. In this example, the fault tree diagram 100 of Figure 1 is being transformed.

The method operates by using cut-set matrices to record the information required for the cut set analysis. A cut-set matrix is a matrix for which every row is a cut-set. For the fault tree diagram 100, the first to fourth columns of a cut-set matrix correspond to the events 1 to 4.

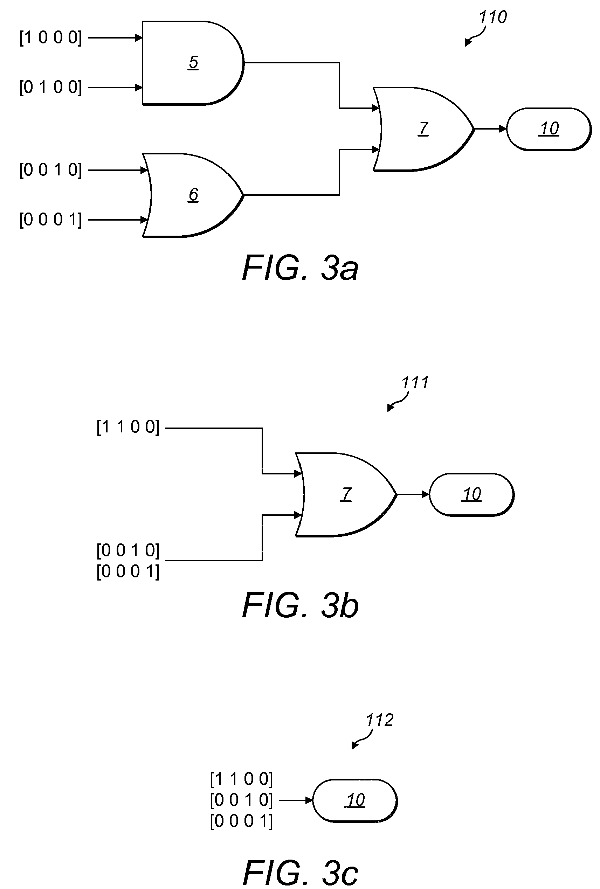

In a first step, the initial inputs to the fault tree diagram, in other words the events 1 to 4, are replaced by corresponding cut-set matrices. In other words, the events 1 and 2 as inputs to the AND gate 5 are replaced by the cut-set matrices [1 0 0 0] and [0100] respectively, and the events 3 and 4 as inputs to the OR gate 6 are replaced by the cut-set matrices [0010] and [0001] respectively, giving the fault tree diagram 110 shown in Figure 3 a.

In a second step, any logic gates of the fault tree diagram 110 which have only cut-set matrices as inputs are "collapsed", and replaced (along with their original inputs) with corresponding cut-set matrices. The methods by which the logic gates are collapsed are described in detail later below. In the fault tree diagram 110 the AND gate 5 and OR gate 6 are collapsed. The AND gate 5 is replaced with the cut-set matrix [1 1 0 0], as both events 1 and 2 must occur for its output to be 1. In contrast, the OR gate 6 is collapsed and replaced with the cut-set matrix $\begin{bmatrix} 0 & 0 & 1 & 0 \\ 0 & 0 & 0 & 1 \end{bmatrix}$, as either the event 3 or 4 alone results in its output being 1. The resulting fault-tree diagram 111 is shown in Figure 3b.

The step of collapsing the logic gates is repeated on the new fault-tree diagram 111. As can be seen, now the OR gate 7 has only cut-set matrices as inputs, and so can be collapsed. In this case it is replaced with the cut-set matrix $\begin{bmatrix} 1 & 1 & 0 & 0 \\ 0 & 0 & 1 & 0 \\ 0 & 0 & 0 & 1 \end{bmatrix}$, to give the result-

ing fault-tree diagram 112 shown in Figure 3c.

A method of collapsing an OR gate in accordance with an embodiment of the invention is now described. This method can be used for example with the embodiment described above.

First, the rows of the cut-set matrices that are the inputs to the OR gate are concatenated. Suppose for example that the OR gate has three inputs which are the following cut-set matrices:

$$\begin{bmatrix} 1 & 0 & 0 & 0 & 0 & 0 \\ 0 & 1 & 0 & 0 & 0 & 0 \end{bmatrix}$$

$$\begin{bmatrix} 0 & 0 & 1 & 0 & 0 & 0 \\ 0 & 0 & 0 & 1 & 0 & 0 \end{bmatrix}$$

$$\begin{bmatrix} 0 & 0 & 0 & 0 & 1 & 0 \\ 0 & 0 & 0 & 0 & 0 & 1 \end{bmatrix}$$

The cut-set matrix obtained by concatenating the rows of these matrices is then as follows:

$$\begin{bmatrix} 1 & 0 & 0 & 0 & 0 & 0 \\ 0 & 1 & 0 & 0 & 0 & 0 \\ 0 & 0 & 1 & 0 & 0 & 0 \\ 0 & 0 & 0 & 1 & 0 & 0 \\ 0 & 0 & 0 & 0 & 1 & 0 \\ 0 & 0 & 0 & 0 & 0 & 1 \end{bmatrix}$$

While in this example the resulting cut-set matrix is a minimal cut-set matrix, depending on the input cut-set matrices the resulting cut-set matrix may contain repeated rows. These can be removed using a method described later below, which can be used on the cut-set matrix resulting from the initial stage of collapsing any type of logic gate.

A method of collapsing an AND gate in accordance with an embodiment of the invention is now described. Again, this method can be used for example with the embodiment described above.

The replacement cut-set matrix has as rows the cut-set obtained by taking each possible combination of rows in the input cut-set matrices, and OR-ing the values for each event. Suppose for example that the AND gate has three inputs which are the following cut-set matrices:

$$\begin{bmatrix} 1 & 0 & 0 & 0 & 0 & 0 \\ 0 & 1 & 0 & 0 & 0 & 0 \end{bmatrix}$$

$$\begin{bmatrix} 0 & 0 & 1 & 0 & 0 & 0 \\ 0 & 0 & 0 & 1 & 0 & 0 \end{bmatrix}$$

$$\begin{bmatrix} 0 & 0 & 0 & 0 & 1 & 0 \\ 0 & 0 & 0 & 0 & 0 & 1 \end{bmatrix}$$

The first possible combination of rows is the first row from each input cut-set matrix. OR-ing the values for the events leads to the new row [1 0 1 0 1 0]. The other combinations are the first, first and second rows respectively, the first, second and first rows respectively, the first, second and second rows respectively, the second, first and first rows respectively, and so on. The cut-set matrix obtained is as follows:

$$\begin{bmatrix} 1 & 0 & 1 & 0 & 1 & 0 \\ 1 & 0 & 1 & 0 & 0 & 1 \\ 1 & 0 & 0 & 1 & 1 & 0 \\ 1 & 0 & 0 & 1 & 0 & 1 \\ 0 & 1 & 1 & 0 & 1 & 0 \\ 0 & 1 & 1 & 0 & 0 & 1 \\ 0 & 1 & 0 & 1 & 1 & 0 \\ 0 & 1 & 0 & 1 & 0 & 1 \end{bmatrix}$$

In this case, it is again possible for there to be repeated rows. Further, the cut-set matrix may non-minimal words, in other words rows that corresponding to cut-sets that are not minimal. These are removed using the method now described.

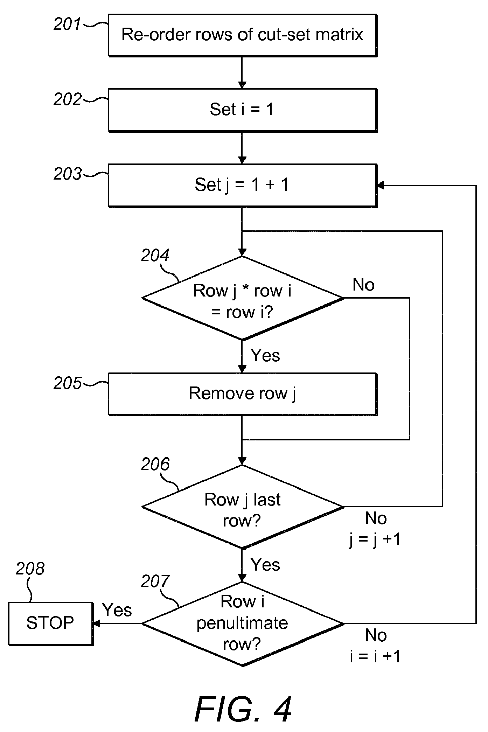

A method of removing repeated and non-minimal rows from cut-set matrices in accordance with an embodiment of the invention, which can be used when collapsing OR and AND gates using the methods described above, is now described with reference to the flowchart of Figure 4. The following example uses the cut-set matrix:

$$\begin{bmatrix} 1 & 1 & 0 & 0 & 0 & 0 \\ 0 & 0 & 0 & 1 & 1 & 0 \\ 1 & 0 & 0 & 1 & 1 & 1 \\ 0 & 0 & 1 & 0 & 0 & 1 \\ 0 & 1 & 0 & 0 & 0 & 0 \\ 1 & 0 & 0 & 0 & 0 & 0 \\ 1 & 1 & 1 & 0 & 0 & 0 \\ 0 & 0 & 1 & 1 & 1 & 1 \end{bmatrix}$$

First, the rows of the cut-set matrix are re-ordered from rows with fewer events occurring to rows with more events occurring (step 201). This results in the following cut-set matrix:

$$\begin{bmatrix} 1 & 0 & 0 & 0 & 0 & 0 \\ 0 & 1 & 0 & 0 & 0 & 0 \\ 1 & 1 & 0 & 0 & 0 & 0 \\ 0 & 0 & 1 & 0 & 0 & 1 \\ 0 & 0 & 0 & 1 & 1 & 0 \\ 1 & 1 & 1 & 0 & 0 & 0 \\ 1 & 0 & 0 & 1 & 1 & 1 \\ 0 & 0 & 1 & 1 & 1 & 1 \end{bmatrix}$$

Next, a variable i is then set to 1 to represent the first row in the cut-set matrix (step 202), and a variable j is set to represent the row subsequent to i, i.e. 2 (step 203).

The product of AND-ing the columns of the row represented by i (i.e. the first row) with the row represented by j (i.e. the second row), represented by row j * row i is then calculated, and compared with row i (step 204). For i = 1 and j = 2 the product is [0 0 0 0 0 0]. If the product is equal to the row represented by i, the row represented by j is removed from the cut-set matrix (step 205). In this case the product is not equal to row i, and so the method simply continues to the next step.

Next, it is checked whether j represents the last row in the cut-set matrix (step 206). If it does not, it is increased by 1 and the product of the new row j with row i is compared to the new row j (step 204 again, followed by subsequent steps).

If j represents the last row, it is checked whether i represents the penultimate row in the cut-set matrix (step 207). If it does not, it is increased by 1, j is re-set to be the row subsequent to i, and the product of the new row j with the new row i is compared to the new row j (step 204 again, followed by subsequent steps).

If i represents the penultimate row, the method has finished (step 208).

In this way, any repeated and non-minimal rows are removed from the cut-set matrix. For the example cut-set matrix given above, this results in the following cut-set matrix:

$$\begin{bmatrix} 1 & 0 & 0 & 0 & 0 & 0 \\ 0 & 1 & 0 & 0 & 0 & 0 \\ 0 & 0 & 1 & 0 & 0 & 1 \\ 0 & 0 & 0 & 1 & 1 & 0 \end{bmatrix}$$

where it was found that (using the row numbers from the re-ordered cut-set matrix):

$$\text{row } 1 * \text{row } 3 = \text{row } 1$$

$$\text{row } 1 * \text{row } 6 = \text{row } 1$$

$$\text{row } 1 * \text{row } 7 = \text{row } 1$$

$$\text{row } 4 * \text{row } 8 = \text{row } 8$$

leading to rows 3, 6, 7 and 8 (the first, seventh, third and eighth rows respectively in the original cut-set matrix) being removed.

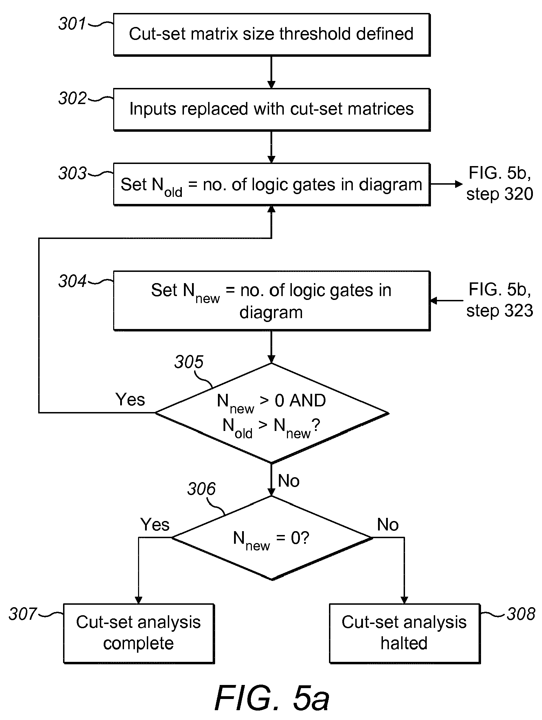

A method of transforming a fault tree diagram in accordance with another embodiment of the invention is now described, with reference to the flowcharts of Figures 5a to 5c. The method is based upon the method described above.

Figure 5a shows the overall operation of the method. First, a threshold size for cut-set matrices of the fault tree is defined by a user (step 301), to give a maximum number of rows that a cut-set matrix in the transformed fault tree diagram can have.

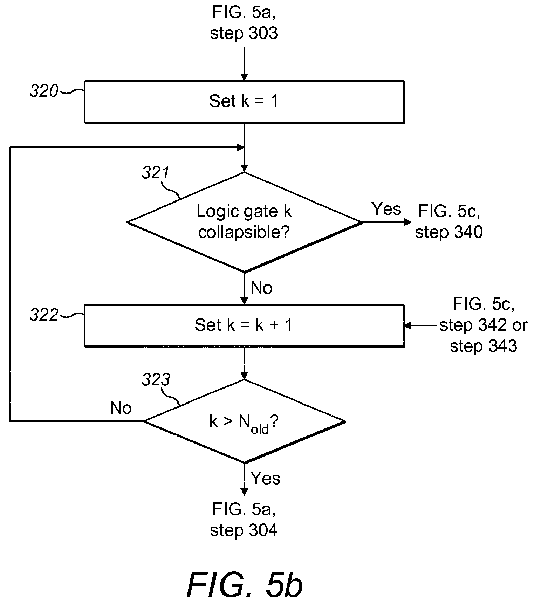

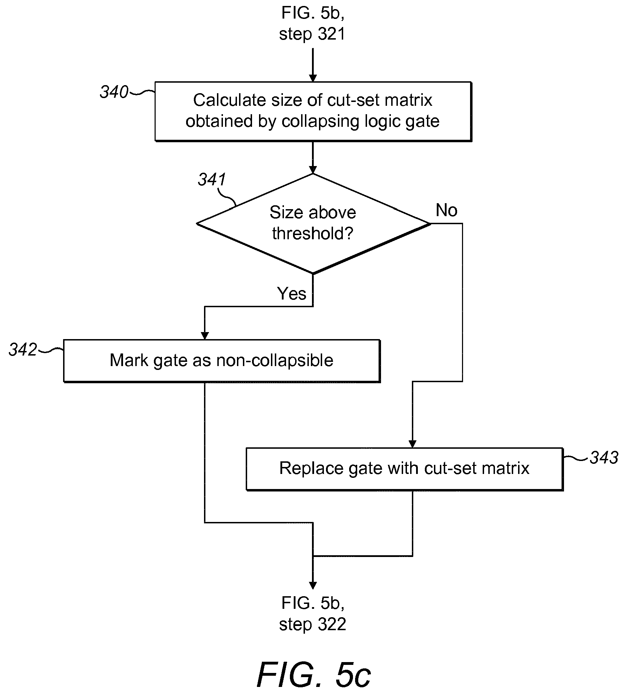

Next, the inputs of the fault tree diagram are replaces with cut-set matrices (step 302), using the method of the previous embodiment. A variable $N_{old}$ is set with the number of logic gates in the fault tree diagram (step 303). A first iteration of transforming the fault tree diagram is then performed, as described below with reference to Figures 5b and 5c.

Once the iteration has been performed, a variable $N_{new}$ is set with the number of logic gates in the fault tree diagram as so far transformed (step 304). It is then checked whether $N_{new}$ is greater than zero, i.e there are still logic gates left in the fault tree diagram, and $N_{old}$ is greater than $N_{new}$, i.e. the last iteration reduced the number of logic gates (step 305).

If so, there still may be logic gates that can be collapsed and so $N_{old}$ is set with the number of logic gates in the fault tree diagram as so far transformed, and the process is repeated (step 303 again, followed by subsequent steps).

If not, there are no more logic gates that can be collapsed. It is then checked whether $N_{new}$ is greater than zero (step 306). If so, the cut-set analysis has complete with all logic gates being replaced (step 307). If not, the cut-set analysis has halted, as it was not possible to replace all logic gates without the size of a resulting cut-set matrix going over the threshold defined by the user (step 308). In the latter case, any cut-set matrices in the transformed fault tree diagram can be replaced with the required original input blocks, so that the fault tree diagram can be manipulated in a conventional fault tree diagram application.

Figure 5b shows a first part of an iteration of transformation of the fault tree diagram. First, following $N_{old}$ being set with the number of logic gates in the fault tree diagram (step 303 above), a variable k is set to equal 1 (step 320). It is then checked whether logic gate k is collapsible (step 321). A gate is determined to be collapsible if it has only cut-set matrices as inputs (i.e. it does not have as inputs the outputs of any other logic gates), and is not marked as non-collapsible. If so, analysis of the logic gate continues as described below with reference to Figure 5c.

If not, k is set to be k + 1 (step 322). It is then checked whether k is greater than $N_{old}$ (step 323), which will be the case all logic gates in the fault tree diagram have been analysed. If not, it is checked whether the new logic gate k is collapsible (step 321 again, followed by subsequent steps).

If k is greater than $N_{old}$ the iteration has completed, and the step of setting the variable $N_{new}$ the number of logic gates in the fault tree diagram as so far transformed is returned to (step 304, followed by subsequent steps). It is noted that further iterations of transformation may occur, as the completed round of iteration may have resulted in gates becoming collapsible that were not previously so as they did not have only cut-set matrices as inputs.

Figure 5c shows a second part of an iteration of transformation of the fault tree diagram. First, following logic gate k being determined to be collapsible (step 321 above), the cut-set matrix obtained by collapsing the logic gate is determined using the method of the previous embodiment, and its size (i.e. number of rows) is determined (step 340).

It is then checked whether the size of the logic gate is above the threshold defined by the user (step 341). If so, the logic gate is marked as non-collapsible (step 342). If not, the logic gate is replaced with the cut-set matrix (step 343). In both cases the step of setting k to be k + 1 is returned to (step 322 above, and subsequent steps).

In this way, the fault tree diagram is transformed by iteratively considering each logic gate it contains and if possible replacing it with a corresponding cut-set matrix, until either no logic gates, or only logic gates for which the replacement cut-set matrix would be larger than the threshold, remain.

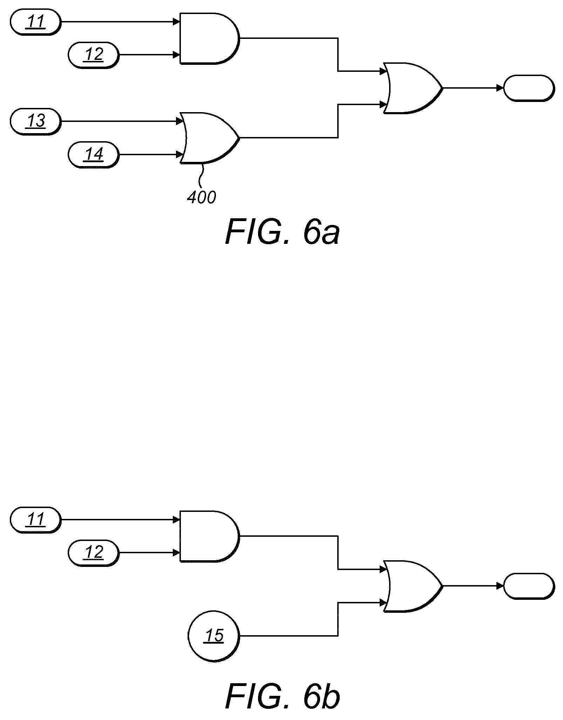

A method of transforming a fault tree diagram in accordance with an embodiment of the invention is now described with reference to Figures 6a to 7b .

In a first step, each input of the fault tree diagram an associated information field, for example a Description field, set to contain the name of the input. A function is then iteratively applied to the fault tree diagram. The function simplifies the fault tree diagram by "collapsing" inputs to OR gates, in some cases along with the OR gates themselves, by replacing them with new inputs, as now described.

On each iteration, for each OR gate in the fault tree diagram it is determined if the OR gate has as inputs a plurality of inputs with the same associated failure mode type. A failure mode type may for example be a pressure sensor failure resulting in loss of indication of system pressure.

In a first example, as shown in Figure 6a, an OR gate 400 has inputs 13 and 14 with the same associated failure mode type, and these are the only inputs to the OR gate 401. (The fault tree diagram also comprises an AND gate with inputs 11 and 12.) In this case, the inputs 13 and 14, and also the OR gate 400, are replaced with a new input 15 (i.e. an input not already used in the fault tree diagram), as shown in Figure 6b. The Description field of the new input 15 is set to contain the names of the replaced inputs 13 and 14, taken from the Description fields for those inputs.

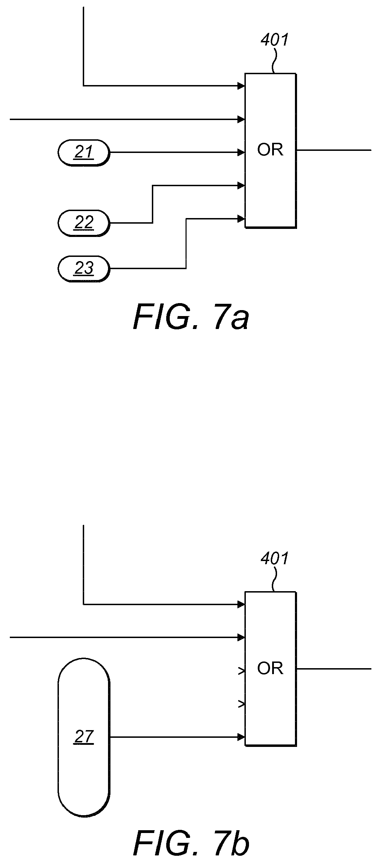

In a second example, as shown in Figure 7a, an OR gate 401 has inputs 21, 22 and 23 with the same associated failure mode type, but also has other inputs without the same associated failure mode type. (These may be inputs associated with a different failure mode type and/or may be outputs of logic gates.) In this case, the inputs 21, 22 and 23 only are replaced by a new input, input 27, as shown in Figure 7b. (In other words, the OR gate 401 itself is not replaced.) Similarly to the previous example, the Description field of the new input 27 is set to contain the names of the replaced inputs 21, 22 and 23, taken from the Description fields for those inputs. As the OR gate 401 is not replaced, it is marked as non-collapsible so that it can be ignored on further iterations.

The above steps are then iterated over the OR gates in the fault tree diagram, ignoring any OR gates marked as non-collapsible. Once all OR gates are marked as non-collapsible, so that on an iteration over each OR gate in the fault tree diagram does not result in any changes to the fault tree diagram, the transformation of the fault tree diagram has finished. This can conveniently be tested for by considering the number of inputs the fault tree diagram has. If the number of inputs has not increased after an iteration, it is necessarily the case that the transformation is complete.

Once complete, the original information obtained from the replaced inputs is stored in a spreadsheet file, which is linked to from the fault tree diagram. This means that information omitted from the fault tree diagram by the transformation is not lost, but can still be accessed in a machine sortable/searchable format.

Whilst the present invention has been described and illustrated with reference to particular embodiments, it will be appreciated by those of ordinary skill in the art that the invention lends itself to many different variations not specifically illustrated herein.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

## Claims

1. A computer-implemented method of transforming a fault tree diagram of an engineering system, wherein the fault tree diagram comprises:

   a plurality of cut-set matrices, wherein for each cut-set matrix, each column of the cut-set matrix corresponds to an event of the system, and each row of the cut-set matrix indicates a combination of occurred events;
   a plurality of logic gates, wherein each logic gate takes as input one or more of the cut-set matrices and/or one or more outputs from other logic gates of the plurality of logic gates;

   wherein the method comprises the steps of:

   1) selecting at least one logic gate that has as inputs one or more cut-set matrices only;
   2) determining a set of events, wherein each event corresponds to a column of the one or more cut-set matrices of the selected logic gate;
   3) determining a replacement cut-set matrix for the selected logic gate, wherein each column of the replacement cut-set matrix corresponds to an event from the set of events, and each row indicates a combination of events obtained from the rows from the one or more cut-set matrices in accordance with the selected logic gate;
   4) replacing the selected logic gate with the replacement cut-set matrix.

2. A computer-implemented method as claimed in claim 1, further comprising prior to step 1 the step of obtaining a threshold for the maximum number rows in a cut-set matrix, and wherein step 4 is performed only in the case that the number of rows in the replacement cut-set matrix is within the threshold.

3. A computer-implemented method as claimed in any claim 1 or 2, further comprising prior to step 1 the steps of:

   obtaining a fault tree diagram of an engineering system comprising:

   a plurality of fault tree inputs, each input corresponding to an event of the system;
   a plurality of logic gates, wherein each logic gate takes as input one or more of the plurality of fault tree inputs and/or one or more outputs from other logic gates of the plurality of logic gates;

   for each input of a logic gate corresponding to an event of the system, determining a corresponding element in a cut-set matrix, wherein one column of the cut-set matrix corresponds to the event of the system, and at least one row of the cut-set matrix indicates the event of the system alone;
   obtaining a replacement fault tree diagram from the obtained fault tree diagram, by replacing the inputs of the logic gates that are events with their corresponding cut-set matrices;
   performing the subsequent steps of the method on the replacement fault tree diagram.

4. A computer-implemented method as claimed in any preceding claim, wherein in step 1 the selected logic gate is an OR gate, and in step 3 the replacement cut-set matrix is determined by concatenating the rows of cut-set matrices that are the inputs to the logic gate.

5. A computer-implemented method as claimed in any preceding claim, wherein in step 1 the selected logic gate is an AND gate, and in step 3 the replacement cut-set matrix is determined by concatenating each combination of rows from each cut-set matrix that is an inputs to the logic gate.

6. A computer-implemented method as claims in claim 4 or 5, further comprising the step of removing redundant rows from the replacement cut-set matrix.

7. A computer-implemented method as claimed in claim 6, wherein the step of removing any redundant rows from the replacement cut-set matrix comprises:

   re-ordering the rows of the replacement cut-set matrix according to the number of occurred events they indicate;
   iterating through the rows in the replacement cut-set matrix, for each iterated row:

for each row that occurs later than the iterated row in the cut-set matrix:

determining a new row by AND-ing each column for an event in the iterated row with the corresponding column for the event in the later row, and
in the case that new row is equal to the iterated row, removing the later row from the replacement cut-set matrix.

8. A computer-implemented method of transforming a fault tree diagram of an engineering system, wherein the fault tree diagram comprises:

a plurality of fault tree inputs, each input corresponding to an event of the system, wherein each event has an associated failure mode type;
a plurality of logic gates, wherein each logic gate takes as input one or more of the plurality of fault tree inputs and/or one or more outputs from other logic gates of the plurality of logic gates;

wherein the method comprises the steps of:

1) selecting at least one logic gate the inputs of which comprise a plurality of inputs corresponding to events of the system, wherein the events have the same associated failure mode type;
2) replacing the plurality of inputs with a new input corresponding to a new event.

9. A computer-implemented method as claimed in any of claims 1 to 7, further comprising the steps of method 8.

10. A computer-implemented method as claimed in any preceding claim, wherein the engineering system is an airplane.

11. A computer-implemented method as claimed in any of claims 1 to 9, wherein the engineering system is an airplane subsystem.

12. A computer system for transforming a fault tree diagram of an engineering system, wherein the computer system comprises:

at least one processor;
memory in communication with the processor;

and wherein the at least one processor is arranged to perform the method of any of claims 1 to 11 on a fault tree diagram stored in the memory.

13. A computer program product arranged, when executed on a computer system, to perform the method of any of claims 1 to 11.

14. A computer program product arranged, when executed on a computer system, to provide the computer system of claim 12.

15. A fault tree diagram transformed using the method of any of claims 1 to 11, or the computer system of claim 12.

*FIG. 1*

*FIG. 2*

FIG. 3a

FIG. 3b

FIG. 3c

201 — Re-order rows of cut-set matrix

202 — Set i = 1

203 — Set j = 1 + 1

204 — Row j * row i = row i?    No

Yes

205 — Remove row j

206 — Row j last row?    No
j = j +1

Yes

208 — STOP    Yes    207 — Row i penultimate row?    No
i = i +1

## FIG. 4

301 — Cut-set matrix size threshold defined

302 — Inputs replaced with cut-set matrices

303 — Set $N_{old}$ = no. of logic gates in diagram → FIG. 5b, step 320

304 — Set $N_{new}$ = no. of logic gates in diagram ← FIG. 5b, step 323

305 — $N_{new} > 0$ AND $N_{old} > N_{new}$? — Yes

No

306 — $N_{new} = 0$? — Yes / No

307 — Cut-set analysis complete

308 — Cut-set analysis halted

# FIG. 5a

FIG. 5a,
step 303

320 — Set k = 1

321 — Logic gate k collapsible?  →  Yes  →  FIG. 5c, step 340

No

322 — Set k = k + 1  ←  FIG. 5c, step 342 or step 343

323 — k > $N_{old}$?

No

Yes

FIG. 5a,
step 304

## FIG. 5b

FIG. 5b,
step 321

340 — Calculate size of cut-set matrix
obtained by collapsing logic gate

341 — Size above
threshold?                    No

Yes

342 — Mark gate as non-collapsible

Replace gate with cut-set matrix — 343

FIG. 5b,
step 322

*FIG. 5c*

400

## FIG. 6a

## FIG. 6b

401

21

22

23

OR

FIG. 7a

401

27

OR

FIG. 7b